# EUROPÄISCHE PATENTSCHRIFT

(11) **EP 1 439 984 B1**
(45) Veröffentlichungstag und Bekanntmachung des Hinweises auf die Patenterteilung: **22.11.2006**
(21) Anmeldenummer: 02772048.1
(22) Anmeldetag: 06.09.2002
(51) Int. Cl.: B60R 16/02, H05K 5/02

(54) **BEFESTIGUNGSVORRICHTUNG FÜR EIN ELEKTRISCHES GERÄT**
FASTENING DEVICE FOR AN ELECTRICAL DEVICE
DISPOSITIF DE FIXATION DESTINE A UN APPAREIL ELECTRIQUE

(30) Priorität: 19.10.2001 DE 10151689
(43) Veröffentlichungstag der Anmeldung: 28.07.2004
(73) Patentinhaber: ROBERT BOSCH GMBH, 70442 Stuttgart (DE)
(72) Erfinder: MAYER, Frank, 71640 Ludwigsburg (DE); SCHIEFER, Peter, 74199 Unterheinriet (DE)
(86) Internationale Anmeldenummer: PCT/DE2002/003312
(87) Internationale Veröffentlichungsnummer: WO 2003/037686

(56) Entgegenhaltungen:
- EP-A- 1 263 274
- DE-A- 3 315 448
- DE-A- 10 005 218
- DE-A- 10 105 292
- DE-A- 19 801 006
- US-A- 4 461 593
- US-A- 5 189 358
- US-A- 5 505 483
- US-A- 6 093 977
- PATENT ABSTRACTS OF JAPAN vol. 2000, no. 09, 13. Oktober 2000 (2000-10-13) -& JP 2000 159081 A (DENSO CORP), 13. Juni 2000 (2000-06-13)

## Beschreibung

### Stand der Technik

Die Erfindung betrifft eine Befestigungsvorrichtung für ein elektrisches Gerät, insbesondere ein elektronisches Steuer- oder Regelgerät für eine elektromechanische Anordnung, nach dem Oberbegriff des Hauptanspruchs.

Bei der Anbringung solcher Gehäuse für ein elektrisches Gerät, beispielsweise ein Steuergerät in einem Kraftfahrzeug, müssen oft Gehäusekonzepte mit einer hohen Variantenvielfalt und verschiedensten Schnittstellendefinitionen an bestimmten Stellen im Kraftfahrzeug angebracht werden. Hierzu werden üblicherweise dazu passende Haltewinkel über den Klemmverband der Leiterplatte am elektrischen Gerät einerseits und andererseits mit den tragenden Teilen im Kraftfahrzeug, z.B. an Aggregaten oder Karrosserieblechen, befestigt, was im Betrieb zu einer hohen Schwingbelastung führen kann.

Nächstliegender Stand der Technik ist die DE 100 05 218 A1. Aus einem der dort gezeigten Ausführungsbeispiele ist ein tragendes Teil bekannt, das paarweise Tragschlitze aufweist, die je Paar zur Aufnahme eines elektrischen Geräts vorgesehen sind. Die dort offenbarten, mehrere Paare Tragschlitze dienen dazu, einheitlichen Gehäusetypen zur Befestigung zu dienen.

### Vorteile der Erfindung

Eine Befestigungsvorrichtung für ein elektrisches Gerät, mit mindestens einem Befestigungselement, das am das elektrische Gerät tragenden Teil und im Gehäuse des elektrischen Geräts verankert ist, ist erfindungsgemäß in vorteilhafter Weise dadurch weitergebildet, dass am Gehäuse und am das Gehäuse tragenden Teil eine derart übereinstimmend angeordnete geometrische Verteilung der Vorrichtungen zur Aufnahme der Befestigungselemente vorgenommen ist, dass die Vorrichtungen am Gehäuse jeweils nur einem Teil der Vorrichtungen am tragenden Teil in der Einbaulage gegenüber liegen und ein Teil der Vorrichtungen am tragenden Teil nicht benutzt ist. Dabei bildet das tragende Teil eine mechanische Standardschnittstelle zur Befestigung einer jeweils unterschiedlichen Baugröße des elektrischen Geräts.

Mit der Erfindung können Befestigungskonzepte z.B. für Kraftfahrzeugsteuergeräte auf einfache und kostengünstige Weise im Baukastensystem verwirklicht werden, da Steuergeräte mit unterschiedlichen Ausfithrungsformen, wie z.B. in dichter oder undichter Bauweise und in verschiedenen Baugrößen über dieselbe mechanische Schnittstelle mit dem Fahrzeug verbunden werden können. Dadurch, dass die Befestigungsvorrichtung innerhalb der Gehäusekontur des Geräts liegt, können die kundenspezifischen Einbaumaße leicht eingehalten werden. Durch die Vereinheitlichung der Befestigungspunkte unabhängig von der Ausführungsform des Steuergeräts mit jeweils gleichen Bohrabständen, gleichen Schraubdomhöhen und z.B. gleichartigen Schrauben als Befestigungselemente können eine Vielzahl von unterschiedlichen Befestigungsvarianten eingespart werden.

Vorteilhaft ist außerdem, wenn die Vorrichtungen am Gehäuse Einschraubdome sind, in die selbstfurchende Schrauben als Befestigungselemente einschraubbar sind. Über diese Art von Anscbraubpunklen kann beispielsweise auch zusätzlich die vom Gehäuse abzuführende Verlustwärme abgeführt werden, was sich positiv auf den Einbauort und die Leistungsfähigkeit des Geräts auswirkt.

Weiterhin ist es vorteilhaft, wenn bei einem Gehäuse für ein elektrisches Steuergerät für eine elektromechanische oder elektronische Anordnung in einem Kraftfahrzeug, die. Schaltungsteile des Steuergeräts, insbesondere die Leiterplatte, mit von den Befestigungselementen für die Anbringung an den tragenden Teilen separierten Befestigungen am Gehäuse gehalten sind. Der Klemmverband im Inneren des Gehäuses mit der Leiterplatte der Schaltungsanordnung bleibt gemäß der Erfindung von eingekoppelten Schwingbelastungen über die separate Befestigungsvorrichtung unberührt, wodurch die Schwingfestigkeit des Geräts verbessert ist.

Die Endmontage des elektrischen Geräts kann in vorteilhafter Weise vor der Montage eventuell notwendiger weiterer Haltewinkel erfolgen, so dass auch hier erhebliche Kosten für Werkstückträger eingespart werden können. Es kann somit insgesamt eine Kostenverringerung durch die vereinfachte Entwicklung und Erprobung der Gehäuse erreicht werden und es entstehen geringere Fertigungskosten durch die Verringerung der Teilezahl aufgrund kundenübergreifender flexibler Standarbefestigungskonzepte und durch die geringeren Rüstkosten der insgesamt vereinfachten Einrichtung.

### Zeichnung

Ausführungsbeispiele eines erfindungsgemäßen Gehäuses für ein elektrisches Steuergerät für ein Fahrzeug werden anhand der Zeichnung erläutert. Es zeigen:
Figur 1 eine Ansicht eines elektrischen Steuergeräts zur Befestigung an einem Karrosserieteil eines Fahrzeugs mit einer ersten Anordnung der Befestigungselemente,
Figur 2 eine Ansicht eines elektrischen Steuergeräts zur Befestigung an einem Karrosserieteil eines Fahrzeugs mit einer zweiten Anordnung der Befestigungselemente und
Figur 3 eine gemeinsame Darstellung verschiedener Halteteile für die Befestigung der Gehäuse der Geräte.

### Beschreibung der Ausführungsbeispiele

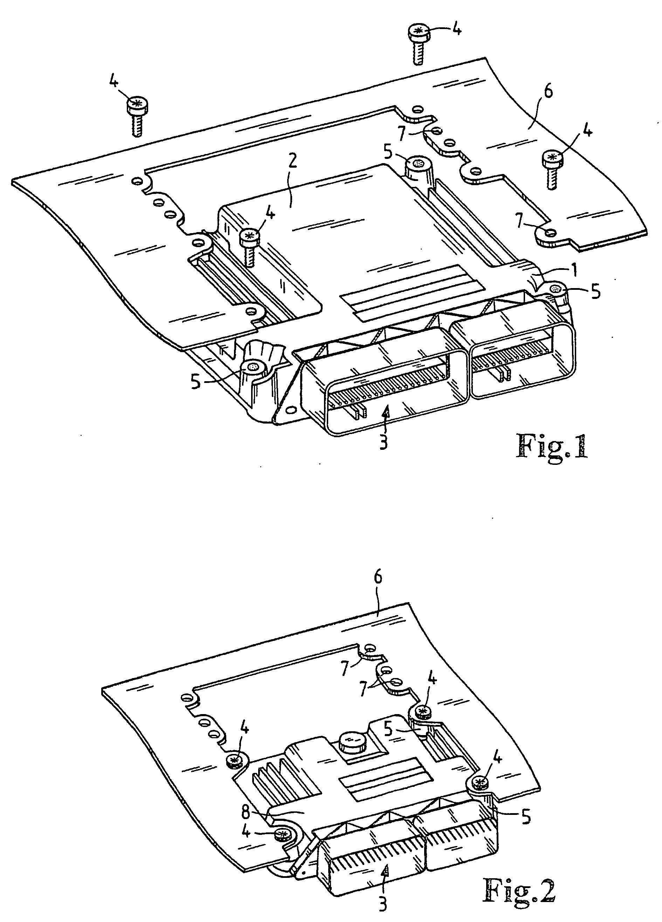

Figur 1 zeigt eine Explosionsansicht einer Anordnung mit einem Steuergerät 1, von dem hier nur das Gehäuse 2 und eine Messerleiste 3 zur Kontaktierung elektrischer Anschlüsse des Steuergeräts 1 mit den hier nicht dargestellten zu steuernden elektromechanischen oder weiteren elektronischen Anordnungen in einem Kraftfahrzeug ersichtlich ist.

Das Gehäuse 2, bzw. ein als Druckgussteil hergestellter Deckel des Gehäuses 2, weist für die Aufnahme von selbstfurchenden oder standardisierten metrischen Schrauben 4 als Befestigungselemente Schraubdome 5 auf, welche gebohrt, geschnitten oder gegossen sein können.

Zur Befestigung des Gehäuses 2 weist ein tragendes Teil 6, das hier entweder Teil eines Karosseriebleches des Kraftfahrzeuges oder ein Haltewinkel ist, eine vorgegebene Anordnung von Aufnahmelöchern auf, durch die die Schrauben 4 zur Befestigung des Gehäuses 2 am tragenden Teil 6 geführt werden können. Aufgrund der sich immer an der gleichen Stelle befindlichen Schraubpunkte 5 am Gehäuse und der Löcher 7 am tragenden Teil 6 ist eine mechanische Standardschnittstelle gebildet, mit der sowohl unterschiedliche Steuergeräte 1, wie z.B. dichte oder undichte Geräte bzw. Geräte mit unterschiedlichen Gesamtbreiten in der selben Schraubstation einer Fertigungsanlage montiert werden können.

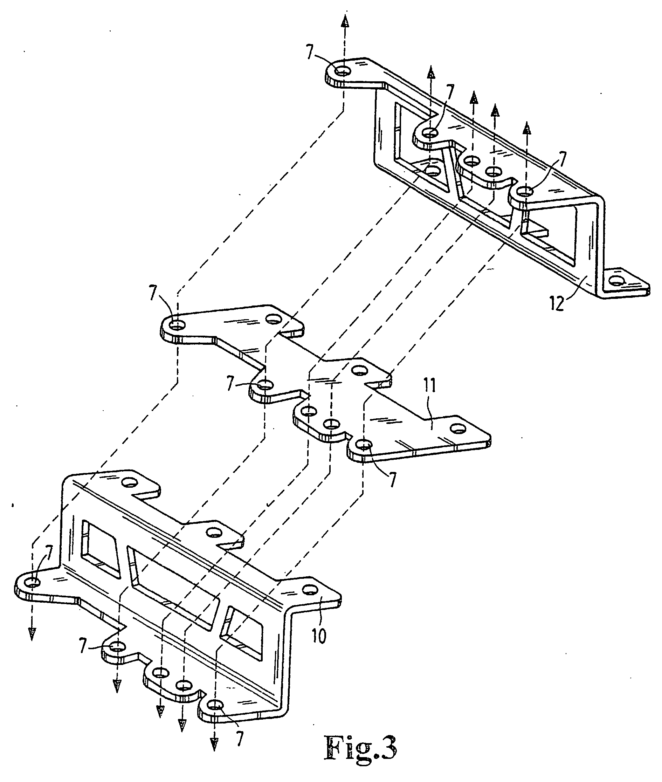

Durch das erfindungsgemäß vorgegebene Lochbild im tragenden Teil 6 und im Gehäuse 2 nach der Figur 1 kann somit auch ein Gehäuse 8 nach Figur 2 in einer wesentlich kleineren Ausführung mit geringeren Lochabständen an dieselbe geometrische Konstruktion des tragenden Teils 6 angefügt werden.

Aus Figur 3 sind noch verschiedene Ausführungsbeispiele von Halteteilen 10, 11 und 12 zu entnehmen, die ebenfalls alle die mechanische Standardschnittstelle mit den Aufnahmelöchern 7 für die Befestigungselemente 4 nach den Figuren 1 und 2 aufweisen. Als Befestigungselemente 4 können bei allen Ausführungsbeispielen auch Nietverbindungen, angeschweißte Muttern, Gewindebolzen oder sonstige Schraubenformen zur Anwendung kommen.

## Patentansprüche

1. Befestigungsvorrichtung für ein elektrisches Gerät (1), mit mindestens einem Befestigungselement (4), das am das elektrische Gerät (1) tragenden Teil (6; 10; 11; 12) und im Gehäuse (2) des elektrischen Geräts (1) verankert ist, **dadurch gekennzeichnet, dass** am Gehäuse (2) und am das Gehäuse (2) tragenden Teil (6; 10; 11; 12) eine derart übereinstimmend angeordnete geometrische Verteilung der Vorrichtungen (5, 7) zur Aufnahme der Befestigungselemente (4) vorgenommen ist, dass die Vorrichtungen (5) am Gehäuse (2) jeweils nur einem Teil der Vorrichtungen (7) am tragenden Teil (6; 10; 11; 12) in der Einbaulage gegenüberliegen und ein Teil der Vorrichtungen (7) am tragenden Teil (6; 10; 11; 12) nicht benutzt ist, derart, dass das tragende Teil (6; 10; 11; 12) eine mechanische Standardschnittstelle zur Befestigung einer jeweils unterschiedlichen Baugröße des Gehäuses (2) des elektrischen Geräts (1) bildet.

2. Befestigungsvorrichtung nach Anspruch 1, **dadurch gekennzeichnet, dass** die Vorrichtungen am Gehäuse (2) Einschraubdome (5) sind, in die selbstfurchende Schrauben (4) als Befestigungselemente einschraubbar sind.

3. Befestigungsvorrichtung nach Anspruch 1, **dadurch gekennzeichnet, dass** das Gehäuse (2) im Inneren ein elektrisches Steuergerät für eine elektromechanische oder elektronische Anordnung in einem Kraftfahrzeug aufweist, wobei die Schaltungsteile des Steuergeräts, insbesondere die Leiterplatte, mit von den Befestigungselementen (4) für die Anbringung an den tragenden Teil (6) separierten Befestigungen am Gehäuse (2) gehalten ist.

## Claims

1. Fixing apparatus for an electrical device (1), having at least one fixing element (4), which is anchored to the part (6; 10; 11; 12) bearing the electrical device (1) and in the housing (2) of the electrical device (1), **characterized in that** a geometrical distribution of the apparatuses (5, 7) for accommodating the fixing elements (4) is carried out on the housing (2) and on the part (6; 10; 11; 12) bearing the housing (2), which geometrical distribution is arranged in a corresponding manner such that the apparatuses (5) on the housing (2), in the installed position, are in each case only opposite some of the apparatuses (7) on the bearing part (6; 10; 11; 12), and some of the apparatuses (7) on the bearing part (6; 10; 11; 12) are not used such that the bearing part (6; 10; 11; 12) forms a mechanical standard interface for fixing in each case a different physical size of the housing (2) of the electrical device (1).

2. Fixing apparatus according to Claim 1, **characterized in that** the apparatuses on the housing (2) are screw-in domes (5), into which self-tapping screws (4) can be screwed as fixing elements.

3. Fixing apparatus according to Claim 1, **characterized in that** the housing (2) has, in the interior, an electrical control device for an electromechanical or electronic arrangement in a motor vehicle, the circuit parts of the control device, in particular the printed circuit board, being held on the housing (2) by fixings which are separate from the fixing elements (4) for the attachment to the bearing part (6).

## Revendications

1. Dispositif de fixation d'un appareil électrique (1) comportant au moins un élément de fixation (4), ancré sur la partie (6 ; 10 ; 11 ; 12) portant l'appareil électrique (1) et dans le boîtier (2) de l'appareil électrique (1),
**caractérisé en ce que**
sur le boîtier (2) et sur la partie (6 ; 10 ; 11 ; 12) portant le boîtier (2), on réalise une répartition géométrique concordante des équipements (5, 7) pour recevoir les éléments de fixation (4) de manière à ce que, sur le boîtier (2), les équipements (5) ne se trouvent face qu'à une partie des équipements (7) sur la partie portante (6 ; 10 ; 11 ; 12) en position montée et qu'une partie des équipements (7) sur la partie portante (6 ; 10 ; 11 ; 12) ne soit pas utilisée de sorte que la partie portante (6 ; 10 ; 11 ; 12) constitue une interface mécanique standard permettant de fixer un boîtier (2) de taille différente de l'appareil électrique (1).

2. Dispositif de fixation selon la revendication 1,
**caractérisé en ce que**
les équipements sur le boîtier (2) sont des dômes de vissage (5) dans lesquels on visse les vis auto-taraudeuses (4) en tant qu'éléments de fixation.

3. Dispositif de fixation selon la revendication 1,
**caractérisé en ce que**
le boîtier (2) contient un appareil de commande électrique, pour un dispositif électromécanique ou électronique d'un véhicule automobile, les pièces de commutation de l'appareil de commande, en particulier la plaque de circuit imprimé, étant maintenues sur le boîtier (2) par des fixations séparées des éléments de fixation (4) pour l'attache sur la partie portante (6).
